# FASCICULE DE BREVET EUROPEEN

(11) **EP 2 138 454 B1**
(45) Date de publication et mention de la délivrance du brevet: **16.03.2011**
(21) Numéro de dépôt: 09290474.7
(22) Date de dépôt: 22.06.2009
(51) Int. Cl.: B81C 1/00, H03H 3/007

(54) **Procédé de réalisation d'un composant à partir d'un substrat comportant une couche sacrificielle en silicium monocristallin**
Herstellungsverfahren für ein Bauteil ausgehend von einem Substrat mit einer Opferschicht aus einkristallinem Silizium
Method of manufacturing a device using a substrate having a monocrystalline silicon sacrificial layer.

(30) Priorité: 23.06.2008 FR 0803496
(43) Date de publication de la demande: 30.12.2009
(73) Titulaire: Commissariat à l'Énergie Atomique et aux Énergies Alternatives, 75015 Paris (FR)
(72) Inventeur: Perruchot, François, 38000 Grenoble (FR); Diem, Bernard, 38130 Echirolles (FR); Larrey, Vincent, 38140 La Murette (FR); Clavelier, Laurent, 38000 Grenoble (FR); Defay, Emmanuel, 38340 Voreppe (FR)
(74) Mandataire: Rataboul, Xavier

(56) Documents cités:
- EP-A- 1 905 734
- DE-A1-102006 032 195

## Description

La présente invention concerne la réalisation d'un composant, notamment un système électromécanique (MEMS), à partir d'un substrat hétérogène comportant une couche sacrificielle.

Les technologies dites de surface (par opposition aux technologies de volume) permettent de réduire la taille des structures électromécaniques réalisées sur silicium. Ces technologies reposent sur l'utilisation d'un empilement d'au moins trois couches : la couche mécanique (typiquement de 0,1µm à 100µm), la couche sacrificielle (typiquement de 0,1µm à 5µm) et le support (typiquement de 10µm à 1000 µm), la gravure chimique sélective de la couche sacrificielle permettant de réaliser dans la couche mécanique des structures actives localement non liées au support. Les zones non gravées de la couche sacrificielle permettent de réaliser des zones dites d'ancrage par lesquelles la structure mécanique est reliée au support.

Un procédé donné est en particulier caractérisé par le choix du couple couche mécanique - couche sacrificielle et de la méthode permettant de les associer au support. Le choix d'un procédé se fait suivant des critères différents suivant le type de composant réalisé mais pour disposer d'un procédé flexible apte à s'adapter à une large gamme de demande, les principaux critères technologiques retenus sont :
- la qualité de la couche mécanique, en premier lieu la stabilité de ses propriétés mécaniques mais aussi la précision sur son contrôle dimensionnel, en particulier sur son épaisseur),
- la possibilité de contrôler les dimensions latérales des zones d'ancrage par insertion dans la couche sacrificielle de zones non attaquées par la gravure chimique pour ne pas dépendre d'un contrôle par temps de gravure qui est sensible à la géométrie de la structure,
- la possibilité de disposer d'au moins un ou plusieurs niveaux d'interconnexion électrique au dessus ou/et en dessous de la couche mécanique, pouvant servir d'électrodes si nécessaires,
- la compatibilité avec l'ajout d'un capot silicium en particulier pour les structures inertielles,
- la possibilité de disposer d'épaisseurs distinctes de silicium sur le même composant.

La famille de procédés la plus utilisée repose sur le couple silicium (couche mécanique) sur silice (couche sacrificielle) associé à une gravure sélective de la silice par HF (liquide ou en phase vapeur). Cette famille fait partie des procédés MEMS SOI (pour Silicon on Insulator, c'est-à-dire silicium sur isolant).

Les procédés MEMS SOI les plus simples réalisent les deux couches SiO2/Si par dépôts successifs des matériaux, par exemple PECVD (dépôt chimique en phase vapeur assisté par plasma) ou LPCVD (dépôt chimique en phase vapeur à basse pression) sur un support en silicium (substrat silicium massif). Ces procédés sont avantageux car,
- le contrôle de l'épaisseur de la couche mécanique est obtenu par le temps de dépôt de la couche de silicium,
- les zones d'ancrage sont très bien contrôlées puisque qu'il est possible d'utiliser directement la couche mécanique en gravant localement la couche d'oxyde avant le dépôt de silicium,
- il est possible de réaliser différents niveaux d'interconnexions.

Cependant, le silicium composant la couche mécanique déposé sur de l'oxyde est du silicium polycristallin ce qui rend plus difficile le contrôle de ses qualités mécaniques (contrôle du niveau des contraintes, stabilité, ...) et limite l'épaisseur pouvant être obtenue.

Des améliorations connues de ces procédés permettent d'utiliser comme couche mécanique du silicium monocristallin dont les propriétés mécaniques sont considérées comme supérieures avec une gamme d'épaisseurs accessibles plus importante.

Il est possible de citer trois grandes familles de procédés connus pour la réalisation d'un MEMS en silicium monocristallin par la technologie MEMS SOI (système électromécanique MEMS sur substrat de type silicium sur oxyde), familles qui se distinguent par la méthode retenue pour réaliser le substrat comportant l'empilement complet :
1) Le substrat de base est un substrat de type SOI ayant une couche fine en Si de type microélectronique d'épaisseur contrôlée (typiquement de l'ordre de 100 nm), par exemple réalisé à partir de la technologie de clivage dite "Smart Cut" (marque déposée). La couche de SiO₂ qui sert d'isolation par rapport au substrat est utilisée comme couche sacrificielle et la couche de silicium fin sert de base à une épitaxie pour conserver son caractère monocristallin.

Il est par ailleurs connu de réaliser des niveaux d'interconnexions au dessus d'une couche mécanique et des ancrages en SiN ou Si polycristallin comme dans l'article "Polysilicon Packaging and a new anchoring Technology for Thick SOI MEMS - Dynamic Response model and application to over-damped inertial sensors" de B. DIEM et collaborateurs (13th Int'I conference on Solid State Sensors Actuators and Microsensors Seoul, 5-9 June 2005, p. 527 - 530).
2) Le substrat de base est un substrat de silicium comportant une couche d'oxyde. La couche mécanique est réalisée par collage d'un second substrat de silicium épais qui est ensuite aminci par rectification et polissage (cf Demande PCT WO 2006/035031). Avec ce procédé, la couche sacrificielle est utilisée comme couche d'adhésion et la qualité de collage est critique car il doit garantir que la gravure chimique sera homogène. L'implémentation de zones d'ancrage dans la couche sacrificielle avant collage est possible mais elle demande de maîtriser le collage de substrats avec des surfaces hétérogènes.
3) Le substrat de base est un substrat de silicium épais sur lequel sont déposées la couche sacrificielle d'oxyde puis une multicouche de fonctionnalisation en SiN associé à du Si polycristallin et enfin une couche finale de collage en Si polycristallin. Cet empilement initial est collé sur un second substrat de silicium servant de support. Le substrat épais de base est ensuite aminci par rectification et polissage pour réaliser la couche mécanique qui sert pour le système électromécanique (cf. l'article "Capacitive Accelerometer with high aspect ratio single crystallin silicon Microstructure using the SOI structure with polysilicon-based Interconnect Technique de T. YAMAMOTO et collaborateurs (publié dans MEMS 2000, the thirteenth annual international conference, 23-27 janvier 2000, Miyazaki, Japan p. 514-519). Le procédé proposé permet de réaliser des zones d'ancrage en Si polycristallin, des couches d'interconnexion et des électrodes enterrées et la couche d'adhésion est distincte de la couche sacrificielle ce qui fait que la qualité du collage est moins critique, car il n'a alors que des fonctions mécaniques.

Dans le cas de structures inertielles, il est nécessaire de réaliser un capot au dessus de la structure mécanique à la fois pour la protéger mais aussi pour assurer le contrôle de l'atmosphère dans laquelle est la structure (pression et composition). Ce capot ne doit pas ajouter de manière directe ou indirecte de contraintes au composant (en particulier lorsque le substrat de base est aminci pour diminuer l'épaisseur totale du dispositif).

Une première solution est de placer une structure MEMS découpée dans un boîtier. Cette technologie non collective augmente de manière significative le coût du composant et son volume total.

Les technologies connues pour réaliser de manière collective une protection au dessus d'un MEMS sont de deux types :
- soit par scellement d'une tranche de silicium comprenant des cavités au dessus des structures MEMS. C'est ce qui est par exemple proposé pour le procédé avec un scellement de type dit « glass-frit » et un passage de contact par-dessous la structure (comme par exemple dans le Brevet US 6 391 673)
- soit par réalisation d'un capot en couche mince. Par exemple il est possible pour le procédé 1 ci-dessus de réaliser un capot en Si polycristallin au dessus de la structure MEMS, comme par exemple dans l'article précité de B. DIEM.

Les solutions de report d'une tranche de silicium demandent d'utiliser un troisième substrat. La technologie de scellement nécessite une surface de collage suffisante pour assurer la tenue mécanique, ce qui augmente la surface totale du composant.

Il existe des solutions pour reporter un capot en silicium en assurant une connexion électrique (référence AuSn sur composant : QIAN WANG et collaborateurs, Application of Au-Sn Eutectic Bonding in Hermetic Radio-Frequency Microelectromechanical System Wafer Level Packaging Journal of ELECTRONIC MATERIALS, Vol. 35, No. 3, 2006). Ces technologies ne sont pour l'instant maîtrisées au niveau industriel qu'à l'échelle du composant et de plus la connexion se fait via un alliage métallique dont la réalisation est complexe.

La solution associée au procédé 1 ci-dessus repose sur l'utilisation d'un dépôt en Si polycristallin et elle permet de transférer des contacts par le capot. Mais la nature du dépôt utilisé demande un contrôle de la contrainte qui est industriellement délicat. Ce contrôle est d'autant plus nécessaire si le support est aminci pour diminuer l'épaisseur totale du composant. De plus l'épaisseur du capot est limitée à une dizaine de microns ce qui rend difficile l'utilisation de la face du capot pour des technologies d'intégration à trois dimensions.

Or, il n'est pas possible dans les procédés de type SOI utilisant une couche mécanique monocristalline de structurer cette couche mécanique dans la troisième dimension.

Les principales solutions connues pour réaliser les MEMS sur silicium reposent en effet sur l'utilisation d'une couche sacrificielle en oxyde. L'avantage de ce choix est l'excellente sélectivité de la gravure de l'oxyde avec arrêt sur silicium qui est le matériau le plus généralement utilisé comme couche mécanique. Mais il n'est pas possible de déposer par épitaxie un matériau monocristallin sur une telle couche ce qui oblige à trouver des méthodes alternatives pour réaliser l'ensemble support, couche sacrificielle et couche mécanique lorsque l'on souhaite obtenir une couche mécanique en matériau monocristallin. De fait, cette couche sacrificielle oxyde n'est pas un bon candidat pour structurer la couche mécanique en y incluant une zone sacrificielle.

Une solution connue pour réaliser une couche sacrificielle compatible avec l'épitaxie de silicium consiste à utiliser le SiGe comme couche sacrificielle car il est possible de réaliser une épitaxie de SiGe sur silicium et de silicium sur SiGe. La limitation de cette solution est l'épaisseur de SiGe qui peut être obtenue sans générer une contrainte importante dans la couche silicium monocristallin déposée ensuite. De plus la sélectivité de la gravure du SiGe avec arrêt sur Si est moyenne.

Une autre solution connue consiste à utiliser du Si poreux. Le Si poreux peut être réalisé à la surface d'un substrat de silicium sans limite contraignante d'épaisseur et il est ensuite possible d'épitaxier une nouvelle couche de Si (voir article de P Steiner, A Richter and W Lang, « Using porous silicon as a sacrificial layer », J. Micromech. Microeng. 3 (1993) 3236). La limitation de cette solution est la relativement faible sélectivité de la gravure du Si poreux avec arrêt sur Si.

L'idée de base de l'invention est de s'affranchir au moins d'une des limitations de l'art antérieur en proposant un procédé de fabrication d'un substrat ayant une nouvelle couche sacrificielle compatible avec l'épitaxie du silicium ou d'un autre matériau monocristallin, qui ne soit pas limité à de faibles épaisseurs et qui offre une bonne sélectivité vis-à-vis d'au moins une gravure chimique avec au moins le silicium.

L'invention concerne ainsi un procédé de fabrication d'un substrat hétérogène destiné notamment à la réalisation d'un système électromécanique, ce substrat comportant une première et une deuxième parties en au moins un matériau monocristallin, lequel comporte une couche sacrificielle constituée par un empilement comportant au moins une couche de Si monocristallin située entre deux couches de SiGe monocristallin, cet empilement étant disposé entre lesdites premières et deuxième parties en matériau monocristallin, tel que défini dans la revendication 1.

Il est de la sorte possible de réaliser une couche sacrificielle qui peut être gravée avec une bonne sélectivité par rapport au moins au silicium et compatible avec l'épitaxie du silicium ou d'un autre matériau monocristallin, éventuellement à partir de couches de transition, y compris pour des épaisseurs supérieures au micron et qui permet en particulier de réaliser des structures tri-dimensionnelles dans une couche mécanique en matériau monocristallin.

Le matériau monocristallin peut être en effet du silicium comme cité précédemment utilisé pour ses propriétés mécaniques, mais il est également intéressant de pouvoir réaliser d'autres matériaux sous forme monocristalline pour obtenir, y compris à faible épaisseur, des propriétés physiques proches des propriétés du monocristal massique. C'est le cas par exemple des oxydes ferroélectriques comme le PZT qui peut être réalisé par épitaxie à partir d'une couche de transition réalisée à partir de silicium monocristallin, la couche de PZT obtenue ayant des propriétés piezoélectriques potentiellement supérieures, à celles des films amorphes ou polycristallin réalisés par dépôt ou sol-gel (voir l'article Epitaxial growth of Pb(Zr0.2Ti0.8)O3 on Si and its nanoscale piezoelectric properties, A. Lin et collaborateurs, Applied Physics Letters, volume 78-14 du 2 avril 2001). La couche mécanique monocristalline peut donc être un multicouche de différents matériaux monocristallins.

La première et une deuxième parties étant séparées par une couche sacrificielle réalisée à partir d'un empilement constitué d'une couche de Si monocristallin sacrificiel encadrée par deux couches de SiGe monocristallin, la couche de Si sert à ajuster l'épaisseur de la couche sacrificielle et les couches de SiGe servent d'arrêt de gravure lors de la libération d'un système électromécanique avec une très bonne sélectivité. Les couches de SiGe peuvent ensuite être gravées rapidement avec arrêt par exemple sur Si, la sélectivité étant suffisante.

La couche sacrificielle peut recouvrir l'ensemble de la surface du substrat ou être localisée.

Il est possible de réaliser successivement plusieurs couches sacrificielles de ce type dans un même substrat.

La première partie peut être en un matériau monocristallin compatible avec une épitaxie de SiGe monocristallin (par exemple un substrat Si ou un substrat à base de Si comportant une couche rapportée par exemple par collage d'un autre matériau monocristallin).

La deuxième partie peut être en au moins un deuxième matériau monocristallin apte à être épitaxié à partir de SiGe monocristallin (par exemple en Si, en SrTiO₃/PZT ou SrTiO₃O₃/PZT).

L'empilement peut comporter au moins une zone enterrée.

L'invention permet par exemple de réaliser un capot en silicium monocristallin pour les structures inertielles mais aussi d'intégrer dans le même dispositif des éléments mécaniques de différentes épaisseurs, soit l'une à coté de l'autre, par exemple pour réaliser des capteurs de sensibilité différente sur le même composant, soit l'une sur l'autre ou encore de réaliser des électrodes au dessus de la couche mécanique.

**La Demande de** DE 10 2006032195 **montre en sa** **figure 6** **un substrat comportant plusieurs couches fonctionnelles de Si monocristallin entre lesquelles a été déposé du SiGe. Les seules couches sacrificielles sont les couches en SiGe.**

Plus précisément, l'invention a pour objet un procédé de réalisation d'un composant à partir d'un substrat hétérogène comportant une première et une deuxième parties en au moins un matériau monocristallin, et une couche sacrificielle constituée par au moins un empilement d'au moins une couche de Si monocristallin située entre deux couches de SiGe monocristallin, cet empilement étant disposé entre lesdites première et deuxième partie en matériau monocristallin, le procédé consistant à graver ledit empilement en réalisant :
e) au moins une ouverture (20) dans la première et/ou la deuxième parties et la première et/ou la deuxième couche de SiGe de façon à déboucher sur la couche de Si,
f) une élimination de tout ou partie de la couche de Si.

Il peut être prévu un enlèvement desdites première et deuxième couches de SiGe.

Le procédé peut être caractérisé en ce que l'étape de gravure comporte entre les étapes e et f, une étape de protection des flancs de la ou des ouvertures par réalisation d'une couche d'oxyde de protection.

La couche d'oxyde de protection peut être réalisée par oxydation thermique.

Après d, le procédé peut comporter une planarisation de la deuxième couche épitaxiée en matériau monocristallin si les couches en SiGe ne couvrent pas la totalité de la surface.

Lesdites régions en SiGe monocristallin peuvent être obtenues par une épitaxie sur la surface complète suivie d'une attaque chimique sélective après masquage pour laisser subsister au moins une dite région.

La première partie peut être en un premier matériau monocristallin compatible avec une épitaxie d'un matériau de SiGe.

La deuxième partie peut être en au moins un deuxième matériau monocristallin apte à être épitaxié à partir de SiGe monocristallin.

Un dit deuxième matériau monocristallin peut être choisi parmi le Si, SrTiO₃/PZT et le SrTiO₃/SrRuO₃/PZT.

L'empilement peut comporter au moins une zone enterrée.

Le procédé précédent peut comprendre les étapes suivantes de réalisation du substrat hétérogène, à partir d'un substrat comportant une dite première partie en matériau monocristallin :
a) épitaxie sur ladite première partie, d'une première couche de SiGe monocristallin,
b) épitaxie d'une couche de Si monocristallin
c) épitaxie d'une deuxième couche de SiGe monocristallin, et
d) épitaxie de ladite deuxième partie de matériau monocristallin, au moins sur la couche épitaxiée à l'étape c).

La première et/ou la deuxième couche en SiGe peuvent être localement gravées avant les épitaxies des étapes b et/d.

Après b et avant c, des tranchées peuvent être réalisées dans la couche de Si jusqu'à la première couche de SiGe, pour former des arrêts de gravure latéraux.

La première et/ou la deuxième couches de SiGe ont avantageusement des épaisseurs comprises entre 40 et 150 nm.

On notera que l'article "Local buried oxide technology for HV transistors integrated in CMOS" de E. SAARNILEHTO et collaborateurs, paru dans Proceedings of the 19th International Symposium on Power Semiconductor Devices & ICs, May 27-30, 2007 Jeju, Korea, p. 81 à 84, prévoit de réaliser successivement une épitaxie de SiGe puis de Si pour réaliser des couches enterrées en SiGe, mais cela ne permet pas de former une cavité enterrée dont la largeur et l'épaisseur peuvent être choisies à volonté au sein d'un substrat monocristallin car seule la couche de SiGe est gravée chimiquement pour réaliser la cavité. L'épaisseur de la cavité est donc limitée à l'épaisseur de SiGe et sa largeur est limitée par la sélectivité de la gravure de SiGe avec arrêt sur Si. D'autre part, les Demandes de Brevet FR 2 876 219 et FR 2 876 220 permettent de réaliser des régions enterrées en SiO₂, mais nécessitent un collage d'un substrat en Si.

De préférence, le procédé met en oeuvre entre b et c la gravure d'au moins une tranchée destinée à former un arrêt de gravure latéral.

Le procédé selon l'invention permet notamment de graver sélectivement la couche sacrificielle grâce à :
- la réalisation à travers l'une des couches en matériau monocristallin de la premiere (respectivement deuxième partie) du substrat hétérogène, d'au moins une ouverture s'étendant au moins jusqu'à une première (respectivement deuxième) région en SiGe monocristallin, et de préférence jusqu'à la première couche épitaxiée en Si monocristallin,
- la réalisation ou le dépôt d'une couche en un matériau protecteur sur les parois d'au moins une ouverture si le Si ne peut pas être gravé simultanément avec arrêt sur SiGe et les matériaux de la première (respectivement deuxième) partie ; par exemple il est possible d'utiliser de l'oxyde comme couche de protection si la partie comportant les ouvertures comprend du silicium, oxyde qui peut être obtenu par oxydation thermique du silicium,
- l'enlèvement sélectif à travers la ou les ouvertures d'au moins une partie de la région de la première couche épitaxiée en Si monocristallin qui est située entre une première région en SiGe monocristallin et la deuxième couche en SiGe monocristallin pour former au moins une zone libérée (et réalisant une cavité dans le cas du procédé proposé).

Les étapes ci-dessus représentent une méthode de libération de la couche sacrificielle en SiGe, Si et SiGe.

D'autres caractéristiques et avantages de l'invention apparaîtront mieux à la lecture de la description qui va suivre, donnée à titre d'exemple non limitatif, en liaison avec les dessins dans lesquels :
- les figures 1a à 1o illustrent un procédé de réalisation préféré du substrat hétérogène de l'invention ainsi qu'un procédé de réalisation d'un système électro-mécanique MEMS.
- les figures 2a à 2b illustrent un autre procédé utilisant un substrat hétérogène conforme à l'invention comportant une couche piezoélectrique.
- les figures 3a à 3d illustrent un autre procédé conforme à l'invention comportant une couche mécanique associée à une couche sacrificielle selon l'invention.
- et les figures 4 à 9 illustrent la fabrication de 6 structures I à VI, à savoir I (figures 4a à 4c), II (figures 5a et 5b), III (figures 6a et 6b), IV (figures 7a et 7b), V (figures 8a et 8b), et enfin VI (figures 9a à 9c).

La couche sacrificielle proposée repose sur la possibilité connue de graver sélectivement le Si avec arrêt sur SiGe et le SiGe avec arrêt sur Si.

La sélectivité de Si sur SiGe est typiquement supérieure à 500 lorsque par exemple on utilise une gravure à base d'un mélange CF4, CH2F2,N2 et 02. Cette propriété permet de réaliser des cavités avec de forts facteurs de forme avec gravure de Si par arrêt sur SiGe puis gravure du SiGe.

Une fois la cavité en Si gravée, le SiGe est à son tour gravé à partir d'une solution de CF4 avec une sélectivité supérieure à 100. (cf. publication S. Borel et collaborateurs, Control of Selectivity between SiGe ans Si in isotropic Etchnig processes, Japanese Journal of Applied Physics, vol. 43, N° 6B, 2004, PP 3964-3966).

La couche sacrificielle proposée est donc réalisée à partir de trois couches, une couche centrale de Si encadrée par 2 couches de SiGe. La couche centrale de Si est utilisée pour définir l'épaisseur de la couche sacrificielle. La gravure de cette couche sacrificielle est réalisée avec arrêt de gravure sur les couches de SiGe. Les couches de SiGe peuvent ensuite être gravées avec arrêt de gravure sur le silicium.

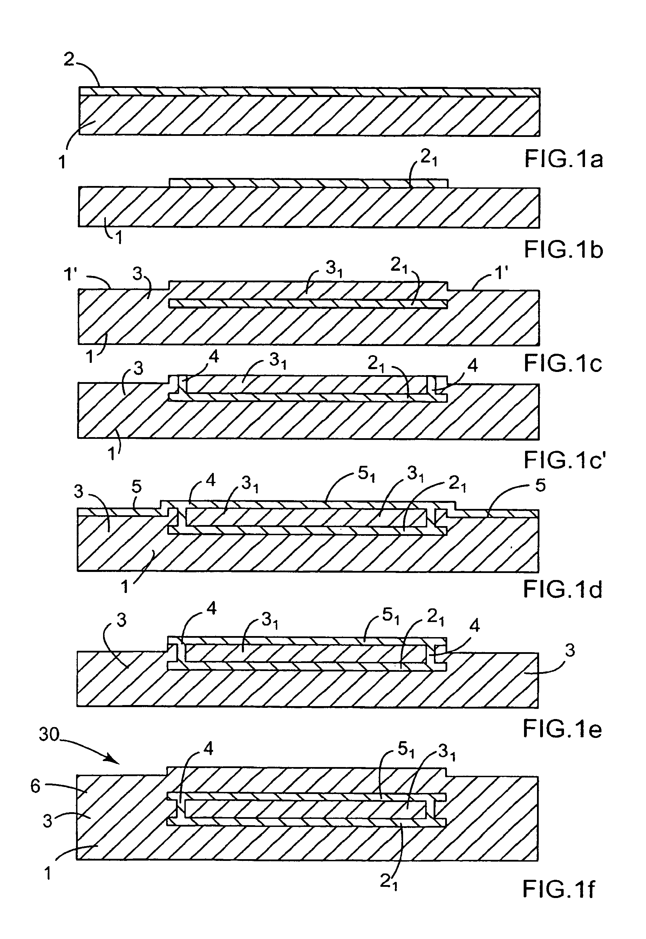

La réalisation de cette couche sacrificielle démarre par l'épitaxie d'une couche 2 de SiGe monocristallin d'épaisseur par exemple entre 10 nm et 300 nm, typiquement 100 nm, et ayant une concentration molaire en Ge comprise entre 20% et 60% sur la surface d'un substrat ayant une couche 1 en matériau monocristallin compatible avec l'épitaxie de silicium, c'est-à-dire ayant une maille cristalline très proche (figure 1a).

On peut utiliser notamment un substrat silicium, ou un substrat SOI (silicium sur isolant).

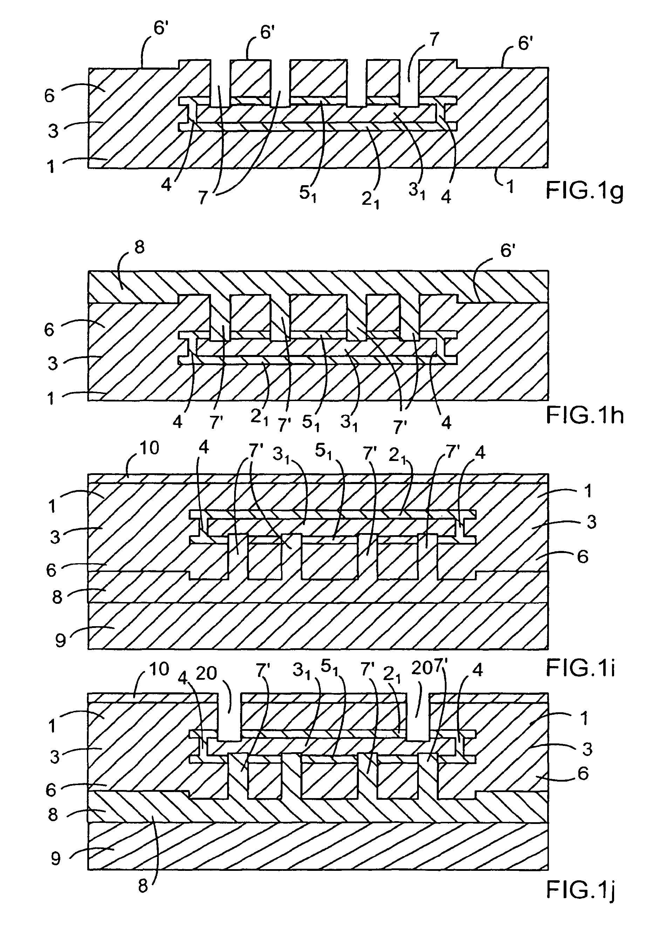

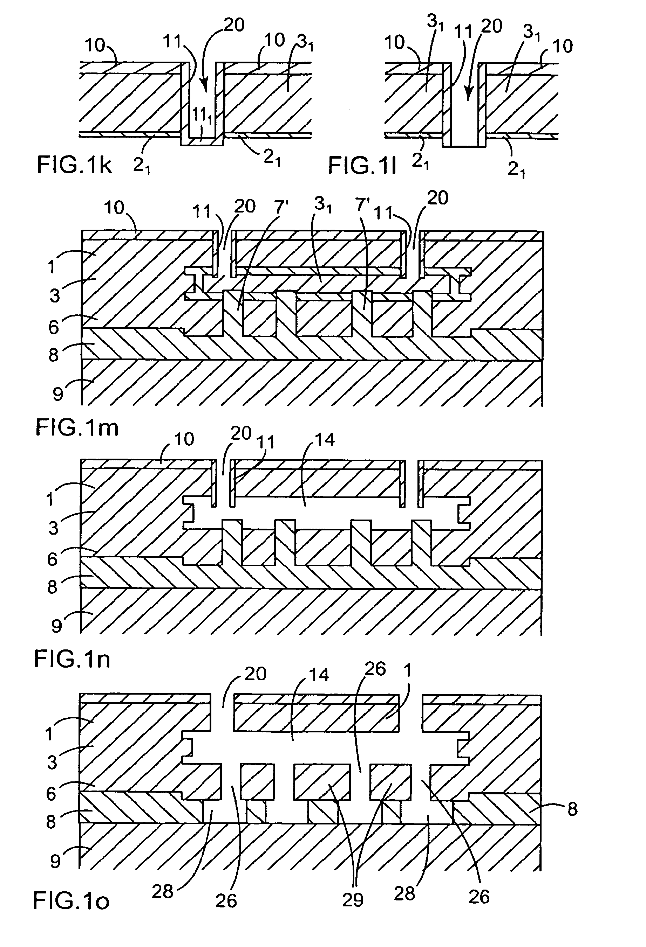

La couche 2 de SiGe est gravée localement pour donner une ou plusieurs régions 2₁ (figure 1 b).

Le choix de l'épaisseur de la couche 2 de SiGe et de la concentration en Ge permet d'épitaxier sur la surface restante 1' du substrat 1 et sur la ou les régions 2₁ (figure 1 c) une couche de Si monocristallin 3 ayant une ou plusieurs régions monocristallines 3₁, avec une qualité suffisante pour que la couche mécanique 6 d'un MEMS qui sera ultérieurement épitaxiée ait des propriétés satisfaisantes.

La figure 1c' montre une étape optionnelle de gravure dans une région 3₁ épitaxiée sur une région 2₁ d'une ou plusieurs tranchées 4 destinées à réaliser des arrêts de gravure latéraux. Ces tranchées 4 peuvent ne s'étendre que jusqu'à la région 2₁ en SiGe, mais il est préférable qu'elles traversent cette région 2₁. Pour des structures relativement simples, il est possible de se dispenser de ces tranchées 4, la gravure s'effectuant alors avec arrêt au bout d'un temps donné adapté à la largeur souhaitée de la gravure latérale.

Une deuxième couche 5 de SiGe monocristallin est ensuite déposée sur la surface (figure 1 d) et elle peut être ensuite gravée pour former (comme représenté) une ou plusieurs régions 5₁, de préférence de même contour que la ou les régions 2₁ (figure 1c).

Cette opération est suivie d'un dépôt épitaxial d'une couche 6 composé d'un ou plusieurs matériaux monocristallin qui est ensuite planarisée par exemple par CMP si les couches de SiGe ne couvrent pas la totalité de la surface (figure 1f), ce qui donne un substrat monocristallin composite 30 contenant une ou plusieurs régions 3₁ en Si monocristallin qui sont en sandwich entre deux régions 2₁ et 5₁ en SiGe monocristallin, ces régions étant elle-mêmes incluses dans un substrat épitaxié 1, 3, 6 en Si monocristallin. Cette étape de planarisation est optionnelle car la topologie provient de l'épaisseur des 2 couches de SiGe (typiquement 20 à 50 nm) et non pas de l'épaisseur de la couche intermédiaire de silicium (1 à plusieurs microns).

Le substrat hétérogène 30 réalisé est donc un substrat en matériaux monocristallins qui comporte une région de silicium délimitée par deux plans parallèles de SiGe typiquement de 40 à 150 nm d'épaisseur (voir ci-dessous). Les deux plans parallèles de SiGe permettent d'utiliser cette région de silicium comme couche sacrificielle (couche sacrificielle Si dans du Si) car il est possible de graver sélectivement le Si en s'arrêtant sur le SiGe avec une très bonne sélectivité.

La description suivante donne un exemple de procédé utilisant la couche sacrificielle faisant l'objet de l'invention pour la réalisation de couches mécaniques en silicium monocristallin. Combinée à une autre couche sacrificielle réalisée en SiO2, elle permet de proposer une solution permettant par exemple de réaliser un capot intégré pour des MEMS inertiels.

Les étapes 1g à 1k détaillent la réalisation d'un système MEMS à partir du substrat hétérogène 30, dont l'une et/ou l'autre des couches 1 et 6 peut être utilisée comme couche mécanique pour un système électromécanique MEMS.

La figure 1g illustre une réalisation de tranchées 7 par exemple par gravure par le procédé DRIE à travers la couche épitaxiée 6 en Si avec arrêt après une couche 5₁ en SiGe.

La figure 1h illustre le dépôt d'une couche sacrificielle par exemple en SiO₂ qui remplit les tranchées 7 et qui recouvre en 8 la surface 6' de la couche épitaxiée 6. Les tranchées remplies portent la référence 7'. La couche sacrificielle 8 peut être planarisée par exemple par planarisation chimico-mécanique CMP. Elle sert par exemple de couche sacrificielle pour libérer le système MEMS.

Il est également possible lorsque l'épaisseur et la dimension des tranchées ne se prêtent pas au remplissage (forte épaisseur avec larges tranchées), d'utiliser une couche couvrant les tranchées sans les remplir par exemple en utilisant du PSG. Ce dépôt peut également servir de couche sacrificielle pour libérer le système MEMS et il n'est pas nécessaire de le planariser.

Cette couche sacrificielle au sein d'un substrat tel que proposé peut être utilisée pour la réalisation d'un MEMS. Un substrat 9 en Si est ensuite collé par exemple par collage moléculaire, sur la couche 8 et le substrat est retourné (figure 1i). Il est également possible d'utiliser les techniques de fonctionnalisation de la couche sacrificielle connues (article YAMAMOTO) par exemple pour réaliser une connexion électrique vers la couche mécanique. On pourra donc avant le collage du substrat, réaliser des tranchées dans la couche sacrificielle qui seront remplies par du silicium polycristallin dopé servant également à réaliser des pistes d'interconnexion. L'ensemble sera recouvert par une couche de nitrure puis par une couche d'adhésion en Si poly on en oxyde.

La couche 1 est éventuellement amincie à une épaisseur dépendant de la fonction réalisée par la couche mécanique pour le système MEMS et également limiter le temps de gravure ultérieur des trous et une couche d'oxyde 10 est déposée ou obtenue par oxydation thermique du silicium.

Les figures 1j à 1n illustrent le procédé de gravure de la couche sacrificielle telle que décrite dans l'invention.

La figure 1j illustre la réalisation de trous 20 qui sont gravés dans la couche 1 par exemple par le procédé DRIE et traversent une ou plusieurs région 2₁ en SiGe.

Le bord et le fond des trous 20 sont oxydés (figure 1 k) pour former une couche d'oxyde de protection 11, 11₁ pour permettre la gravure ultérieure des couches 2₁, 3, et 5₁ (figure 1j) de manière à former au moins une cavité 14.

La couche d'oxyde est gravée au fond des trous. La figure 1I montre le substrat après gravure de la couche d'oxyde 11₁ au fond des trous.

La figure 1m illustre la gravure sélective par gravure chimique humide ou par gravure ionique réactive RIE de toute ou partie de la couche de silicium 3₁ à travers les trous de libération 20 pour former une cavité 14. Cette gravure s'arrête sur les couches 2₁ et 5₁ en SiGe et éventuellement sur les régions 4 d'arrêt de gravure latérale. En l'absence des tranchées 4 d'arrêt de gravure latérale, la géométrie de la cavité 14 peut être définie par la disposition spatiale des trous 20 et le temps de gravure.

La figure 1n illustre la gravure sélective (par gravure RIE, cf document S. Borel) de toute ou partie des couches 2₁, 5₁ en SiGe avec arrêt de gravure sur le silicium.

Le procédé décrit utilisant le substrat hétérogène peut se terminer par la libération du système MEMS (figure 1o) par gravure de l'oxyde bordant les trous 20, des tranchées 7' et de la couche sacrificielle 8 pour donner des tranchées décapées 26 et des régions décapées 28 de la couche sacrificielle libérant des régions actives 29 de la couche mécanique 6.

Les figures 1a à 1n décrivent le cas où la cavité est complètement définie par les parois en SiGe. Dans un autre mode de réalisation, il est également possible de ne pas graver les couches 2 et 5 de SiGe afin qu'elles recouvrent tout le substrat et de se passer des arrêts de gravure latéraux. Dans ce cas, la cavité est définie par les deux plans parallèles de SiGe et la position des trous 20 (attaque isotrope du silicium à partir des trous). Ce mode de réalisation permet d'éviter les étapes de gravure sélective des couches de SiGe et de réalisation des arrêts de gravure. L'étape optionnelle de planarisation de la dernière couche épitaxiée de silicium est également supprimée. Ce mode est donc plus simple et moins couteux ; en contre-partie, la géométrie est moins précisément définie mais cela est suffisant lorsque la géométrie demandée pour les cavités est simple. C'est le cas par exemple pour réaliser des capots intégrés.

On obtient ainsi avec le procédé décrit utilisant le substrat hétérogène tel que décrit par l'invention un système MEMS inclus dans un substrat en Si monocristallin dont la couche 1 sert de capot. Elle peut être recouverte d'une couche de verre phosphosilicate PSG recouvrant au moins les tranchées 11.

La couche sacrificielle 8 peut être mise à profit pour réaliser des prises de contact en réalisant des dépôts localisés d'un matériau conducteur par exemple du Si polycristallin dans les tranchées 7 entre les étapes des figures 1g et 1h et/ou bien encore pour réaliser par gravure et dépôt des piliers de renforcement par exemple en nitrure de Si. D'autres tranchées peuvent être ménagées pour réaliser des prises de contact.

La couche sacrificielle 8 peut également recevoir des plages conductrices par exemple en Si polycristallin pour réaliser des interconnexions.

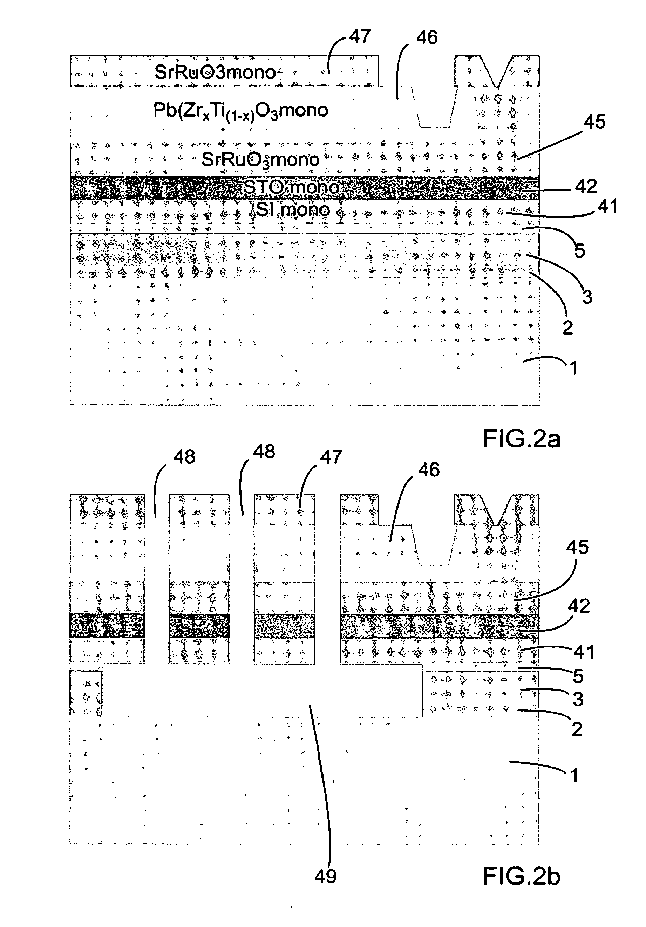

Un second exemple décrit ci-après en relation avec les figures 2a et 2b illustre une utilisation de la couche sacrificielle pour une couche mécanique qui n'est pas du silicium monocristallin.

Il est en effet avantageux de pouvoir utiliser certaines matériaux en couche mince sous la forme de monocristal lorsque cela permet d'obtenir des propriétés physiques, y compris à faible épaisseur, proches des propriétés du monocristal massique ou en tout cas supérieures à celles obtenues pour le même matériau obtenu dans une phase amorphe ou polycristalline. Dans la famille des perovskites, c'est le cas par exemple des oxydes ferroélectriques comme le PZT qui peut être réalisé par épitaxie à partir d'une couche de transition en SrTiO₃ sur du silicium monocristallin avec des propriétés potentiellement supérieures, à celles des films amorphes ou polycristallin réalisés par dépôt ou sol-gel (article cité précédemment de A. Lin et collaborateurs).

La couche sacrificielle composée d'un empilement de SiGe, Si et SiGe est réalisée comme dans les figures 1a à 10 sur un substrat en silicium monocristallin. Une couche de transition composée d'une couche de silicium monocristallin et d'une couche de perovskites STO monocristalline 42 est réalisée par épitaxie (STO correspond à SrTiO₃). L'empilement piezoélectrique est composé d'électrodes 45 en SrRuO3 monocristallin associées à une couche piézoélectrique 46 de PZT selon un procédé connu (article cité précédemment de A. Lin et collaborateurs). Les gravures locales de la première électrode 45 et de la couche 46 de PZT permettent d'utiliser une deuxième couche 47 de SrRuO₃ à la fois pour la première électrode et pour réaliser une connexion électrique vers la deuxième électrode (figure 2a).

Des ouvertures sont réalisées par gravure ionique dans la masse de la structure résonante pour libérer localement la structure piézoélectrique à partir de la gravure de la couche sacrificielle réalisée telle que décrite précédemment (figure 2b), en formant une cavité 49 en éliminant également de la cavité les portions de SiGe comme représenté, ou bien en les conservant.

Le composant ainsi obtenu est un résonateur à ondes acoustiques de volume BAW de type FBAR c'est-à-dire réalisé sur une cavité.

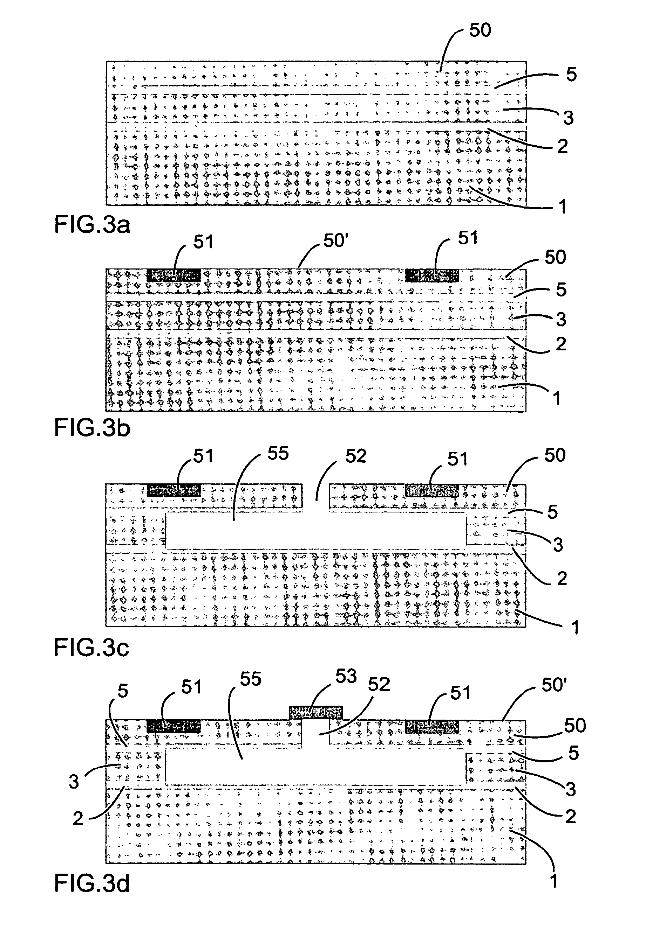

Il est également possible d'utiliser cette couche sacrificielle dans des procédés plus conventionnels utilisant une seule couche sacrificielle tel qu'illustré dans les figures 3a à 3d.

Dans cet exemple de mise en oeuvre de l'invention, la couche sacrificielle ayant été réalisée sur un substrat silicium (figure 3a), il est possible de réaliser des jauges piézorésistives 51 à partir de zones dopées par implantation à la surface 50' de la couche mécanique 50 (type d'implantation opposé à celui de la couche mécanique)(figure 3b), puis de libérer partiellement la couche mécanique à partir de la gravure de la couche sacrificielle telle que décrite ci-dessus (ouvertures 52 réalisées par gravure ionique réactive profonde DRIE puis libération en deux étapes)(figure 3c). Après rebouchage des ouvertures 52 par exemple à partir d'une couche localisée 53 de PSG, à savoir par enlèvement partiel du Si de la couche 3 pour définir la cavité 55 (figure 3a) puis du SiGe des couches 2 et 5 pour terminer la cavité (figure 3d) le dispositif réalisé peut être utilisé comme capteur de pression à détection piezorésistive comprenant une membrane en silicium monocristallin et n'utilisant pas de substrat SOI (figure 3d).

Il est possible de combiner les différentes approches décrites dans les deux modes de réalisation précédent : couche sacrificielle telle que décrite pour réaliser une structure mécanique en silicium monocristallin (figures 1a à 1o) ou d'un ou plusieurs autres matériaux (figures 2a et 2b), la couche sacrificielle de l'invention étant utilisée comme couche sacrificielle principale (figures 2a et 2b) ou comme couche additionnelle pour obtenir une structuration à trois dimensions de la couche mécanique (premier exemple).

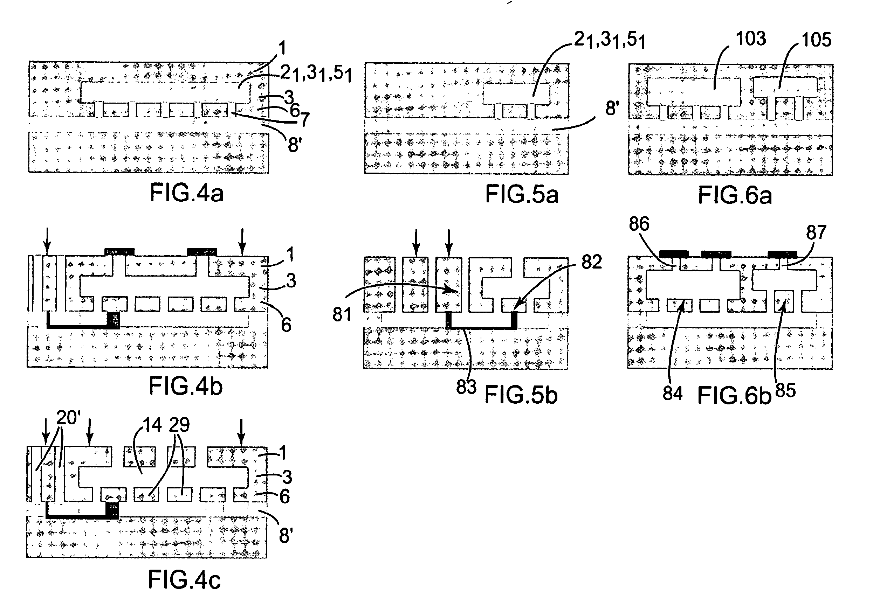

Les figures 4 à 9 illustrent la fabrication de 6 structures utilisant le principe de cavités enterrées. Chaque figure comprend la description du substrat hétérogène associé après l'étape a du procédé puis en fin de procédé. Chaque structure décrite correspond à une géométrie différente de zones de gravure donnée permettant d'illustrer les types de fonctions pouvant être réalisées.

I - Substrat hétérogène (figures 4a à 4c) comportant une unique zone de gravure couvrant la quasi totalité du composant et des tranchées permettant de réaliser un capot intégré (première couche mécanique 1) et structure mécanique (deuxième couche mécanique 6). Cette géométrie correspond aux figures 1a à 1o. Cette configuration lorsqu'elle comprend un rebouchage des ouvertures peut être utilisée pour réaliser une structure inertielle avec un capot intégré. Dans le cas contraire, la première couche mécanique 1 peut être utilisée pour réaliser des électrodes supérieures. Les connexions électriques peuvent être réalisées à partir de la face supérieure du substrat, directement pour les électrodes ou le capot, à travers des piliers en silicium monocristallin et des interconnexions en silicium polycristallin dopé pour la partie mécanique. Ce type de connexions peut être utilisé dans les autres configurations également.

Il - Substrat hétérogène comportant une zone de gravure occupant partiellement l'espace du composant permettant de réaliser deux structures MEMS élastiques 81 et 82 d'épaisseurs différentes dont l'un s'étend jusqu'à la surface et dont l'autre est enterrée, la gravure de la géométrie de la structure épaisse 81 étant réalisée avant la libération des cavités (figures 5a et 5b). Les contacts vers la couche mécanique de plus faible épaisseur peuvent être réalisés à travers une couche d'interconnexion en silicium placée sous et à travers la couche sacrificielle.

III - Substrat hétérogène comportant deux zones de gravure enterrées 103 et 105 d'épaisseurs différentes placées l'une à coté de l'autre (figures 6a et 6b)et couvrant la quasi-totalité du composant et des tranchées 86 et 87permettant de réaliser un composant MEMS avec un capot intégré et deux épaisseurs pour la structure mécanique par exemple pour réaliser deux structures élastiques 84 et 85 d'épaisseurs différentes au sein d'un même accéléromètre ou bien pour deux accéléromètres sur le même composant (mesure de l'accélération dans le plan et hors du plan) ou pour réaliser des électrodes au dessus de la couche mécanique. Lorsque les zones de gravure sont réalisées à partir de trois couches SiGe/Si/SiGe, les gravures profondes des deux couches mécaniques peuvent être simultanées. Sinon il faut utiliser un film sec en débutant par la gravure dont la précision est la plus critique.

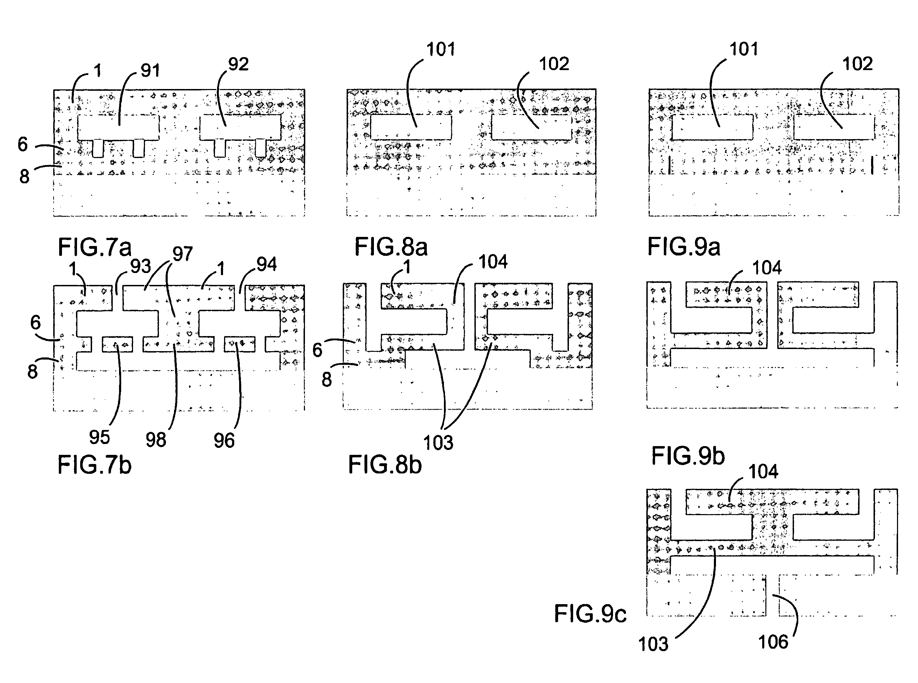

IV - Substrat hétérogène comportant deux zones de gravure 91 et 92 de même épaisseur et dans un même plan et des tranchées 93 et 94 permettant de réaliser un composant MEMS à deux régions superposées reliées entre elles mécaniquement (figures 7a et 7b). Cette configuration peut être utilisée pour la réalisation d'une masse 97 (première couche mécanique 1 épaisse) reliée rigidement par la région 97 à une structure mécanique 98 (deuxième couche mécanique 6 fine),

V - Substrat hétérogène comportant deux zones de gravure 101 et 102 de même épaisseur et dans le même plan, sans tranchées, permettant de réaliser une structure mécanique suspendue fine 103 associée à une masse 104 (figures 8a et 8b). La gravure de la couche sacrificielle se fait à partir d'ouvertures spécifiques.

VI - Substrat hétérogène identique au cas V mais avec soit collage sur cavité ne nécessitant pas de gravure de la couche sacrificielle après collage, soit libération de la structure mécanique par des ouvertures 106 réalisées à partir de la face arrière du composant (figures 9a et 9b).

## Revendications

1. Procédé de réalisation d'un composant à partir d'un substrat hétérogène (30) comportant une première (1) et une deuxième (6) parties en au moins un matériau monocristallin, et une couche sacrificielle constituée par au moins un empilement d'au moins une couche (3) de Si monocristallin située entre deux couches (2, 5) de SiGe monocristallin, cet empilement étant disposé entre lesdites première (1) et deuxième (6) partie en matériau monocristallin, **caractérisé en ce qu'**il consiste à graver ledit empilement en réalisant :
e) au moins une ouverture (20) dans la première (1) et/ou la deuxième (6) parties et la première (2) et/ou la deuxième (5) couche de SiGe de façon à déboucher sur la couche de Si,
f) une élimination de tout ou partie de la couche (3) de Si.

2. Procédé selon la revendication 1, **caractérisé en ce qu'**il met en oeuvre un enlèvement de toute ou partie des première (2) et deuxième (5) couches de SiGe.

3. Procédé selon une des revendications 1 ou 2, **caractérisé en ce qu'**il comporte entre les étapes e et f, une étape de protection des flancs de la ou des ouvertures (20) par réalisation d'une couche d'oxyde de protection (11).

4. Procédé selon la revendication 3, **caractérisé en ce que** la couche d'oxyde de protection est réalisée par oxydation thermique.

5. Procédé selon l'une quelconque des revendications 1 à 4, dans lequel la première partie (1) est en un premier matériau monocristallin compatible avec une épitaxie d'un matériau de SiGe.

6. Procédé selon l'une quelconque des revendications 1 à 5, dans lequel la deuxième partie (6) est en au moins un deuxième matériau monocristallin apte à être épitaxié à partir de SiGe monocristallin.

7. Procédé selon l'une quelconque des revendications 1 à 6, dans lequel un dit deuxième matériau monocristallin est choisi parmi le Si, SrTiO₃/PZT, SrTiO₃/SrRuO₃/PZT).

8. Procédé selon l'une quelconque des revendications 1 à 7, dans lequel ledit empilement comporte au moins une zone enterrée.

9. Procédé selon l'une quelconque des revendications 1 à 8, comprenant les étapes suivantes de réalisation du substrat hétérogène, à partir d'un substrat comportant une dite première partie (1) en matériau monocristallin :
a) épitaxie sur ladite première partie, d'une première (2) couche de SiGe monocristallin,
b) épitaxie d'une couche (3) de Si monocristallin
c) épitaxie d'une deuxième couche (5) de SiGe monocristallin, et
d) épitaxie de ladite deuxième partie (6) de matériau monocristallin, au moins sur la couche épitaxiée à l'étape c).

10. Procédé selon la revendication 9, dans lequel la première (2) et/ou la deuxième (5) couches de SiGe sont localement gravées avant les épitaxies réalisées à l'étape b) et/ou d).

11. Procédé selon l'une quelconque des revendications 9 ou 10, dans lequel après b) et avant c), des tranchées sont réalisées dans la couche (3) de Si jusqu'à la première couche (2) de SiGe.

12. Procédé selon l'une quelconque des revendications 9 à 11, dans lequel la première (2) et/ou la deuxième couche (5) de SiGe ont des épaisseurs comprises entre 40 et 150 nm.

## Claims

1. A method of making a component from a heterogeneous substrate (30) comprising first and second portions (1, 6) in at least one monocrystalline material, and a sacrificial layer constituted by at least one stack of at least one layer (3) of monocrystalline Si situated between two layers (2, 5) of monocrystalline SiGe, the stack being disposed between said first and second portions (1, 6) of monocrystalline material, the method being **characterized in that** it consists in etching said stack by making:
e) at least one opening (20) in the first and/or second portion (1, 6) and the first and/or second layer (2, 5) of SiGe so as to reach the layer of Si; and
f) eliminating all or part of the layer (3) of Si.

2. A method according to claim 1, **characterized in that** it includes removing all or part of the first and second layers (2, 5) of SiGe.

3. A method according to claim 1 or claim 2, **characterized in that** it includes, between steps e) and f), a step of protecting the flanks of the opening(s) (20) by making a protective layer (11) of oxide.

4. A method according to claim 3, **characterized in that** the protective oxide layer is made by thermal oxidation.

5. A method according to any one of claims 1 to 4, wherein the first portion (1) is made of a first monocrystalline material that is compatible with epitaxially growing an SiGe material.

6. A method according to any one of claims 1 to 5, wherein the second portion (6) is made of at least one second monocrystalline material suitable for being grown epitaxially from monocrystalline SiGe.

7. A method according to any one of claims 1 to 6, wherein a said second monocrystalline material is selected from: Si; SrTiO₃/PZT; and SrTiO₃/SrRuO₃/PZT.

8. A method according to any one of claims 1 to 7, wherein said stack includes at least one buried zone.

9. A method according to any one of claims 1 to 8, including the following steps of making the heterogeneous substrate from a substrate including a said first portion (1) of monocrystalline material:
a) epitaxially growing a first layer (2) of monocrystalline SiGe on said first portion;
b) epitaxially growing a layer (3) of monocrystalline Si;
c) epitaxially growing a second layer (5) of monocrystalline SiGe; and
d) epitaxially growing said second portion (6) of monocrystalline material, at least on the layer grown epitaxially in step c).

10. A method according to claim 9, wherein the first and/or the second layer (2, 5) of SiGe is/are locally etched prior to performing the epitaxial growth in step b) and/or d).

11. A method according to claim 9 or claim 10, wherein, after step b) and before c), trenches are made in the layer (3) of Si as far as the first layer (2) of SiGe.

12. A method according to any one of claims 9 to 11, wherein the first and/or the second layer (2, 5) of SiGe has/have thickness lying in the range 40 nm to 150 nm.

## Patentansprüche

1. Verfahren zur Herstellung eines Bauelementes aus einem heterogenen Substrat (30), welches einen ersten (1) und einen zweiten (6) Teil aus mindestens einem monokristallinen Material sowie eine Opferschicht bestehend aus mindestens einer Schichtung von mindestens einer, zwischen zwei Schichten (2, 5) von monokristallinem SiGe liegenden Schicht (3) von monokristallinem Si aufweist, wobei diese Schichtung zwischen dem ersten (1) und dem zweiten (6) Teil aus monokristallinem Material angeordnet ist, **dadurch gekennzeichnet, dass** das Verfahren darin besteht, die Schichtung zu ätzen, indem:
e) mindestens eine Öffnung (20) in dem ersten (1) und/oder dem zweiten (6) Teil und in der ersten (2) und/oder der zweiten (5) SiGe-Schicht so hergestellt wird, dass sie zur Si-Schicht hin offen ist,
f) ein vollständiges oder teilweises Entfernen der Si-Schicht (3) durchgeführt wird.

2. Verfahren nach Anspruch 1, **dadurch gekennzeichnet, dass** es ein vollständiges oder teilweises Abtragen der ersten (2) und der zweiten (5) SiGe-Schicht anwendet.

3. Verfahren nach einem der Ansprüche 1 oder 2, **dadurch gekennzeichnet, dass** es zwischen den Schritten e) und f) einen Schritt des Schützens der Flanken der Öffnung(en) (20) durch Herstellen einer Oxidschutzschicht (11) umfasst.

4. Verfahren nach Anspruch 3, **dadurch gekennzeichnet, dass** die Oxidschutzschicht durch thermische Oxidation hergestellt wird.

5. Verfahren nach einem der Ansprüche 1 bis 4, wobei der erste Teil (1) aus einem ersten monokristallinen Material besteht, das mit einem epitaktischem Aufwachsen eines SiGe-Materials kompatibel ist.

6. Verfahren nach einem der Ansprüche 1 bis 5, wobei der zweite Teil (6) aus mindestens einem zweiten monokristallinen Material besteht, das für ein epitaktisches Aufwachsen aus monokristallinem SiGe geeignet ist.

7. Verfahren nach einem der Ansprüche 1 bis 6, wobei ein solches zweites monokristallines Material aus Si, SrTiO₃/PZT und SrTiO₃/SrRuO₃/PZT ausgewählt ist.

8. Verfahren nach einem der Ansprüche 1 bis 7, wobei die Schichtung mindestens einen vergrabenen Bereich aufweist.

9. Verfahren nach einem der Ansprüche 1 bis 8 mit den folgenden Schritten zur Herstellung des heterogenen Substrates aus einem Substrat, welches einen genannten ersten Teil (1) aus monokristallinem Material aufweist:
a) epitaktisches Aufwachsen einer ersten Schicht (2) von monokristallinem SiGe auf dem ersten Teil,
b) epitaktisches Aufwachsen einer Schicht (3) von monokristallinem Si,
c) epitaktisches Aufwachsen einer zweiten Schicht (5) von monokristallinem SiGe, und
d) epitaktisches Aufwachsen des zweiten Teils (6) aus monokristallinem Material zumindest auf der in Schritt c) aufgewachsenen Epitaxieschicht.

10. Verfahren nach Anspruch 9, wobei die erste (2) und/oder die zweite (5) SiGe-Schicht vor dem Durchführen des epitaktischen Aufwachsens in Schritt b) und/oder d) örtlich begrenzt geätzt wird.

11. Verfahren nach einem der Ansprüche 9 oder 10, wobei nach b) und vor c) Gräben in der Si-Schicht (3) bis zur ersten SiGe-Schicht (2) hergestellt werden.

12. Verfahren nach einem der Ansprüche 9 bis 11, wobei die erste (2) und/oder die zweite SiGe-Schicht (5) jeweils eine zwischen 40 und 150 nm liegende Dicke aufweist.
